# EUROPEAN PATENT APPLICATION

(11) **EP 2 018 028 A1**
(43) Date of publication of application: **21.01.2009**
(21) Application number: 07720766.0
(22) Date of filing: 12.04.2007
(51) Int. Cl.: H04L 29/10

(54) **A DOUBLE-WIDTH ADVANCED MEZZANINE CARD, A COMMUNICATION SYSTEM AND UNIT INCLUDING THE ADVANCED MEZZANINE CARD**

(30) Priority: 20.10.2006 CN 200610152817
(71) Applicant: Huawei Technologies Co., Ltd., Shenzhen, Guangdong Province 518129 (CN)
(72) Inventor: HONG, Feng, Shenzhen Guangdong 518129 (CN); CHEN, Cheng, Shenzhen Guangdong 518129 (CN); LI, Shanfu, Shenzhen Guangdong 518129 (CN); PAN, Jianhua, Shenzhen Guangdong 518129 (CN)
(74) Representative: Casalonga, Axel
(86) International application number: PCT/CN2007/001193
(87) International publication number: WO 2008/049298

(57) **Abstract**

The present invention discloses a double-width Advanced Mezzanine Card, comprising a functional circuit, a first Tongue and a second Tongue; both the first and second Tongues have interfaces that are connected to the functional circuit. The present invention further discloses a communication system with an Advanced Mezzanine Card, wherein a backplane has a slot that can accommodate two single-width AMCs or one double-width AMC; a double-width AMC having a first Tongue and a second Tongue is plugged in the slot; both the first and second Tongues have backplane interfaces, the backplane interfaces are connected to the corresponding backplane interfaces on the slot. The present invention further discloses a communication unit, including an AMC carrier board and a double-width AMC with a first Tongue and a second Tongue; both the first and second Tongues have carrier board interfaces, the carrier board interfaces on both Tongues are respectively connected to the carrier board signals via two AMC Backplane Connectors on the carrier board. The present invention can extend the connection resources of the standard AMC and improve the resource usage efficiency.

## Description

### FIELD OF THE INVENTION

The present invention relates to the technical field of communication equipment, and more particularly, to a double-width Advanced Mezzanine Card (AMC) and a communication system and a communication unit.

### BACKGROUND

MicroTCA is a platform specification developed by PCI Industrial Computer Manafucturers Group (PICMG). MicroTCA utilizes standard AMC modules to construct small-capacity, low-cost modular communication platform mainly used in compact telecommunication equipments of Central Office or industrial-level communication equipments. The current available version of MicroTCI is PICMG MicroTCA.0 R1.0.

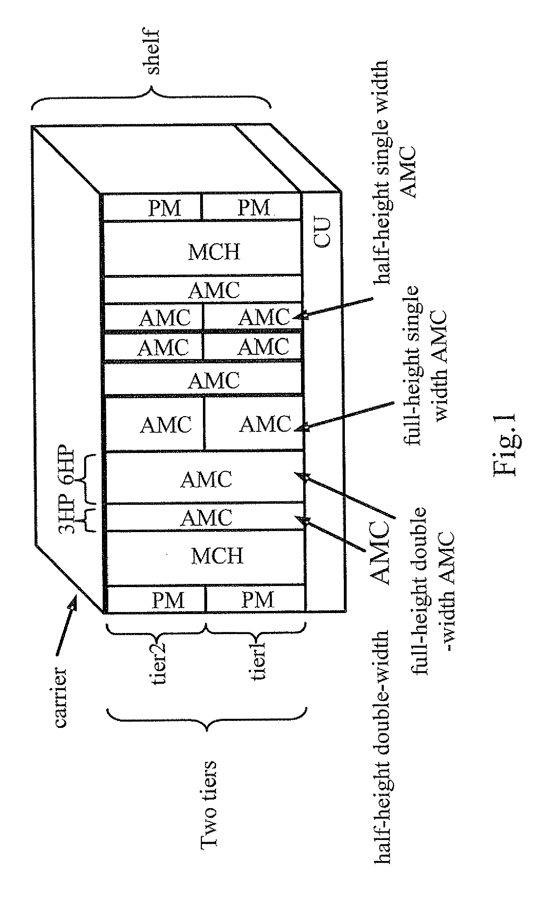

As shown in Fig. 1, in a MicroTCA system, a Carrier includes a Chassis, a Power Module (PM), a MicroTCA system Hub (MCH) and an AMC. A Shelf includes a plurality of Carriers and a Cooling Unit (CU).

An AMC can also function as a subcard which is plugged onto an AMC carrier board of Advanced Telecomm Computing Architecture (ATCA) or onto an AMC carrier board of other forms.

MicroTCA supports a Mixed width AMC of various form factor, and the slots can be allocated according to requirement. It can be seen from Fig. 1 that an AMC slot with a height of 6HP (IHP is equal to 0.2 inch) and a width of 2 Tiers can be configured to accommodate one slot supporting a full-height double-width AMC, or two slots each supporting a half-height double-width AMC, or one slot supporting a half-height double-width slot plus two slots each supporting a half-height single-width AMC, or four slots each supporting a half-height single-width AMC.

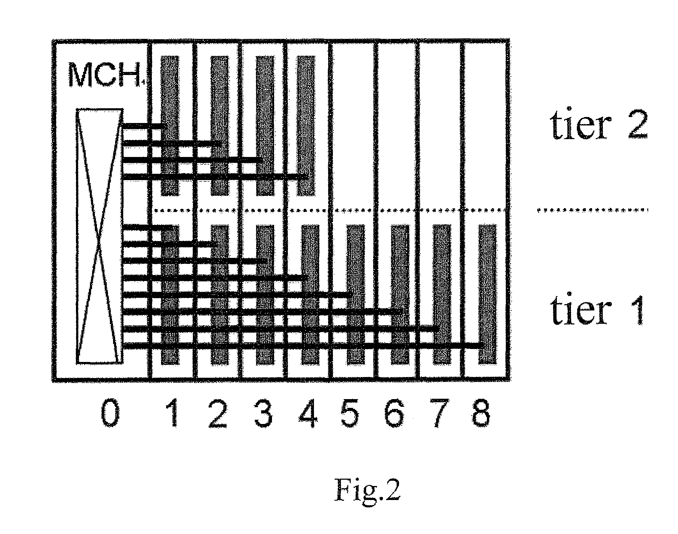

There are Fabric interconnecting links between each slot and the MCH, in order to realize various form factors AMC of flexible configurations. Fig. 2 shows a schematic diagram of the structure of a non-redundant MCH MicroTCA system with Mixed width AMC configuration. Here, slots 1, 2, 3, 4 can support single-width and double-width AMC, and slots 5, 6, 7, 8 can support double-width AMC.

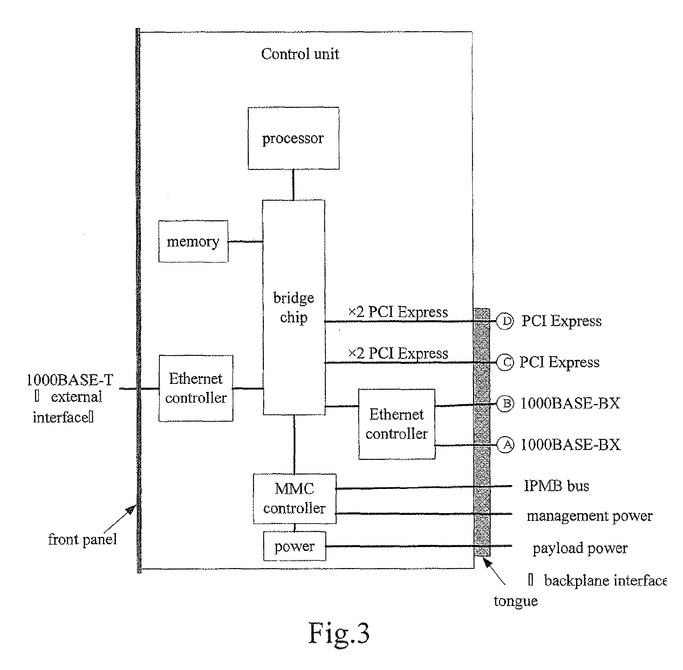

It's stated in the currently available AMC.0 specification that both single-width and double-width AMCs provide only one tongue for connecting with an AMC Connector. The currently available standard double-width AMC includes functional circuits and tongues. The functional circuits comprise modules for realizing each board function respectively, such as Module Management Controller (MMC) and Power etc, so as to perform service processing, system control or network interfacing functions. The tongue provides backplane interfaces for connecting with corresponding chips in the functional circuit. The backplane interfaces include Management Interface, Power Interface and Fabric Interface, which are used for managing the equipment, acquiring the power and communicating with MCH via the AMC Backplane Connector in the slot, respectively, after the AMC has been plugged into the slots on the Chassis. Fig. 3 shows an exemplary structure of a currently available standard double-width AMC, wherein the Management Interface comprises Intelligent Platform Management Bus (IPMB) Interface and Management Power interface. The Power Interface refers to payload power interface, and a Fabric Interface includes two gigabit Ethernet interfaces and two Serial Extended Bus interfaces.

When a half-height double-width AMC is plugged into Slot 1 of Fig.2, since the standard double-width AMC provides only one Tongue for connecting with the AMC Backplane Connector of Tier 1, only Fabric connection resource in Tier is utilized, although the board occupies both Tier 1 and Tier 2. The Fabric connection resource in Tier 2 is idle and the bandwidth of Tier 2 is unavailable.

A double-width AMC provides only one connection to one AMC Backplane Connector, Therefore in the case of standard MicroTCA structure, although different forms of width AMC are supported to Mixed insertion, the Tongue is only connected to the AMC Backplane Connector in Tier 1 without utilizing the connection resource in Tier 2 when a double-width AMC is plugged into a slot supporting both single-width and double-width AMCs, which results in a poor utilization of connection resources. Similarly, the above said disadvantage exists when a double-width AMC is plugged into an AMC carrier board with Mixed width configuration.

### SUMMARY

Embodiments of the present invention provide a double-width Advanced Mezzanine Card, a MicroTCA communication system and a communication unit, which can improve utilization rate of the resources.

A double-width Advanced Mezzanine Card comprises a functional circuit, a first Tongue and a second Tongue;

both the first and second Tongues have interfaces that are connected to the functional circuit.

In a communication system with an Advanced Mezzanine Card, a backplane comprises a slot into which two single-width AMCs can be plugged; the communication system further comprises:

a double-width AMC which is plugged in the slot and has a first Tongue and a second Tongue;

both the first and second Tongues have backplane interfaces, and the backplane interfaces are connected to the corresponding backplane interfaces on the AMC slot.

A communication unit with an Advanced Mezzanine Card includes an AMC carrier board that has a slot to accommodate two single-width AMCs, and a double-width AMC that is plugged in the slot and has a first Tongue and a second Tongue;

both the first and second Tongues have carrier board interfaces, the carrier board interfaces of both Tongues are connected to the signal of the AMC carrier board via two AMC Backplane Connectors of the carrier board, respectively.

The above technical solution achieves the goal of providing more interfaces by one double-width AMC and fully utilizing the connection resources of the double-width AMC, by means of adding an extended Tongue to a standard double-width AMC for providing an interface for connecting with the functional circuits.

### BRIEF DESCRIPTION OF THE DRAWING(S)

Fig. 1 is a block diagram of a MicroTCA system;

Fig. 2 is a block diagram of a non-redundant MCH of a MicroTCA system;

Fig. 3 is a block diagram of an existing standard double-width AMC;

Fig. 4 is a block diagram of an extended double-width AMC according to an embodiment of the present invention;

Fig. 5 is a block diagram of a communication unit including the extended double-width AMC and an AMC carrier board according to a first embodiment of the present invention

Fig. 6 is a block diagram of the extended double-width AMC according to the first embodiment of the present invention when applied in a MicroTCA system;

Fig. 7 is a block diagram of the extended double-width AMC according to the first embodiment of the present invention;

Fig. 8 is a block diagram of a MicroTCA system with Mixed width AMC and non-redundant MCH according to a first embodiment of the present invention;

Fig. 9 is a block diagram of a MicroTCA system with Mixed width AMC and redundant MCH according to a first embodiment of the present invention; and

Fig. 10 is a block diagram of the extended double-width AMC according to a second embodiment of the present invention.

### DETAILED DESCRIPTION

In embodiments of the invention, a standard double-width AMC is extended with one more Tongue, both Tongues on the extend AMC provide interfaces for connecting with functional circuits, thereby more interface resources can be provided compared with the existing standard double-width AMC.

When plugging the extended double-width AMC provided in the embodiments of the invention into an AMC slot, one of the two Tongues is connected to an AMC Backplane Connector in the Tier 1 or to an AMC carrier board, and the other Tongue is connected to an AMC Backplane Connector in the Tier 2 or to the AMC carrier board.

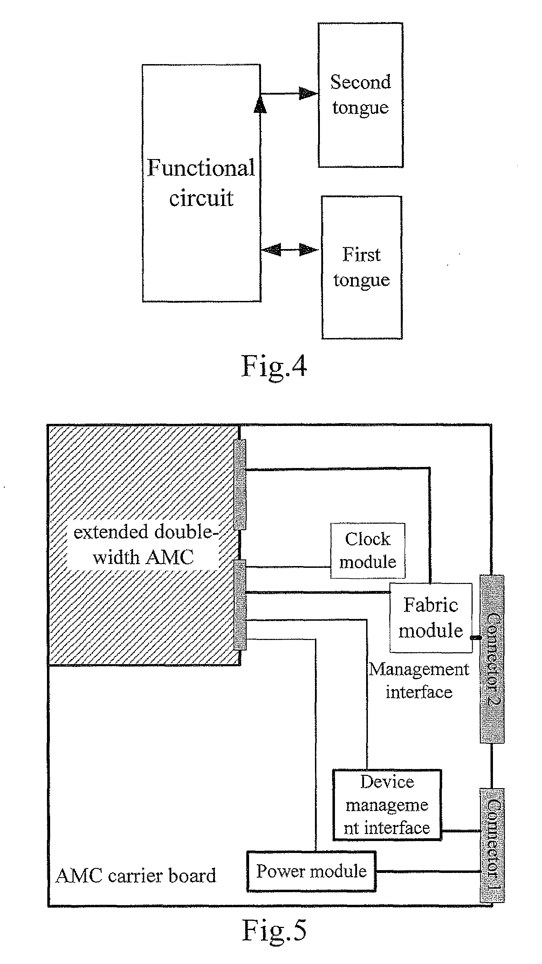

Fig. 4 shows a block diagram of an extended double-width AMC according to an embodiment of the present invention, which includes: a functional circuit, a first Tongue and a second Tongue. The functional circuit is adapted to realize the functions of service processing, system control and network interfacing of a board, and to provide a backplane interconnecting bandwidth that is two times of the existing AMC. The first and second Tongues provide interfaces to the functional circuit respectively, and the interface can be backplane interfaces or carrier board interfaces. The interfaces of the first Tongue include a Fabric Interface, a Power Interface, a Clock Interface, a Management Interface or other universal interfaces, and any combination of the above interfaces. The interfaces of the second Tongue include a Fabric Interface, a Power Interface, a Clock Interface, a Management Interface or other universal interfaces, and any combination of the above interfaces. The interfaces in the first and second Tongues shall collectively include at least a Fabric Interface, a Power Interface, a Clock Interface and a Management Interface. For example, the first Tongue provides a Fabric Interface, a Clock Interface, a Management Interface and a Power Interface, while the second Tongue provides a Fabric Interface. Alternatively, both the first and second Tongues provide a Fabric Interface, a Clock Interface, a Management Interface and a Power Interface. Alternatively, the first Tongue provides a Fabric Interface and the second Tongue provides a Fabric Interface, a Clock Interface, a Management Interface and a Power Interface. The above management interface includes a Management Bus interface and a Management Power interface. The power interface mainly refers to a payload power interface, and the Fabric Interface is a connecting interface for the AMC to communicate with an MCH, or the Fabric Interface is a connecting interface for the AMC to communicate with an AMC carrier board.

In the first embodiment of the present invention, the first Tongue provides a Fabric Interface, a Management Interface and a Power Interface and the second Tongue provides a Fabric Interface. When this embodiment is applied to the AMC.0 standard, the first Tongue provides a signal connection substantially the same with that of the original Tongue, according to the standard, including:

40 Differential signal pairs (20 pairs of Receipt signals and 20 pairs of transmission signals) for Fabric Interface, defined as TX0/RXO TX1/RX1, ... , TX15/RX15, TX17/RX 17, TX18/RX18, ... ,TX20/RX20 respectively;

5 Differential signal pairs for providing the system clock, i.e., FCLKA, TCLKA, TCLKB, TCLKC, TCLKD respectively;

5 JTAG signals;

9 system Management Interface signals (peso#, PS1#, GA0, GA1, GA2, SDA_L, SCL_L, Enable, Management Power(+3.3V));

Power and GND signals (56 GNDs and 8 Payload Power (+12V));

2 reserved signals with no applications defined (RSRVD6, RSRVD8).

A connection for Fabric Interface is added to the second Tongue, totally with 20 RX/TX channels corresponding to TX0/RX0, TX1/RX1, ... , TX15/RX15, TX17/RX 17, TX18/RX18, ... ,TX201RX20 on the AMC Backplane Connector respectively.

In addition to the above Fabric Interface, the second Tongue can also be extended by Power, GND and other signals.

AMC can be used in the MicroTCA system or work as a "Daughter" card plugged into an AMC carrier board of an ATCA system or an AMC carrier board of other forms, therefore, the extended double-width AMC provided by the embodiment can also be used in the MicroTCA system or work as a "Daughter" card plugged into an AMC carrier board of an ATCA system or an AMC carrier board of other forms.

When the extended double-width AMC provided by the embodiment is plugged into an AMC carrier board as a "Daughter" card, there needs to be a slot on the AMC carrier board for two single-width AMCs to plug in, so that, after the extended double-width AMC provided by the embodiment which has two Tongues is plugged into that slot, each of the two Tongues is connected to the two physical ports on the AMC carrier board via the Fabric Interface respectively. On the AMC board, the two physical ports connected to the extended double-width AMC can be configured to be two separate logical ports or work as a single logical port by binding the links of the two physical ports together.

It is apparent that the AMC carrier board includes a slot that can accommodate two single-width AMCs, and further two single-width AMCs, or one standard double-width AMC or one extended double-width AMC provided by the embodiment can be plugged into the slot. When an extended double-width AMC is plugged into, for example, the AMC carrier board in ATCA as show in Fig. 5, a board of the communication system ,called a communication unit includes the extended double-width AMC and the AMC carrier board. In the board, the AMC carrier board includes a backplane connector, a Power Module, a Management Module and a Fabric Module. The backplane connector provides the connection between the board and a backplane of a communication system; the Power Module provides Power Supply for board; the Management Module provides an IPMB management; and the Fabric Module provides AMC with the connections to the carrier board and the communication system. The architecture of the extended double-width AMC is shown in Fig. 4. The two Fabric Interfaces of the extended double-width AMC can be two separate Fabric Interfaces, and the Fabric Modules on the AMC carrier board are configured with two separate logical Fabric Interfaces correspondingly. The two Fabric Interfaces of the extended double-width AMC can also be bound into a single logical Fabric Interface by the configuration performed in the Functional Module, accordingly, the two physical Fabric ports connected to the two Fabric Interfaces are configured to be one logical Fabric port by the Fabric Modules on the AMC carrier board, for providing interconnection between the extended double-width AMC and the AMC carrier board.

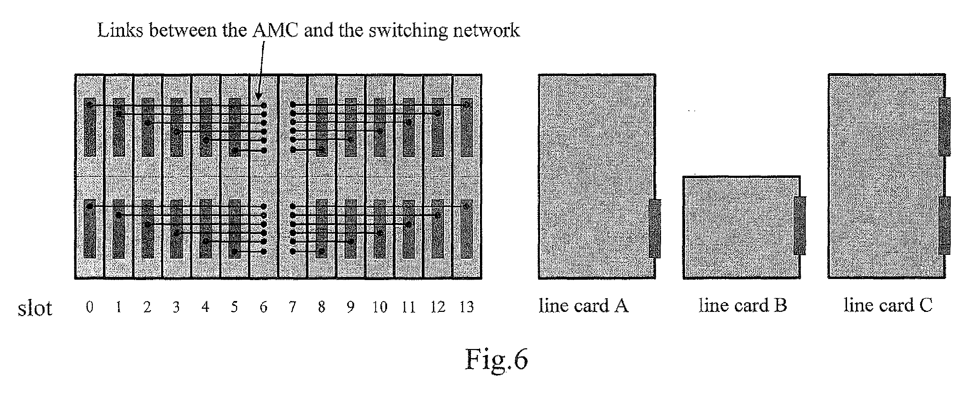

When the extend-double-width AMC provided by this embodiment is applied in a MicroTCA system, the MicroTCA system includes a backplane the backplane has a slot, which can accommodate two single-width AMC as shown in Fig. 6, wherein two single-width AMCs, i.e., line card B in Fig. 6, or an existing standard double-width AMC, i.e., line card A in Fig. 6, or one extended double-width AMC provided by the embodiment, i.e., line card C in Fig. 6 can be plugged into the slot. Compared with the scenario having Line Card A plugged in, the extended double-width AMC provided by the embodiment overcomes the problem of wasting fabric network resource and fully utilizes the Fabric resource and can also provide a doubled switching bandwidth to satisfy the requirement of relatively broad-band service.

In a MicroTCA communication system with Mixed width AMC, there are two Fabric ports in the Fabric corresponding to the extended double-width AMC provided by the embodiment. Both Fabric ports are connected to the two Tongues of the extended double-width AMC via two links respectively. Thus the bandwidth of each of the port on the corresponding Fabric remains unchanged, while the total switching bandwidth of the extended double-width AMC is two times of that of standard AMC. There can be only one Fabric port on the Fabric corresponding to the extended double-width AMC provided by the embodiment. In this case, it is configured in the AMC functional module of the Fabric to bind the two Fabric Interfaces connected to the AMC Backplane Connector as a single logical Fabric Interface, and the two links connected to two Tongues of the extended double-width AMC in the Fabric are bound together to be connected to one Fabric port, thus the bandwidth of the corresponding Fabric port is doubled. Here the communication system can be a MicroTCA communication system or other communication systems supporting Mixed width configured circuit boards.

The embodiment will be explained in detail by referring to a MicroTCA communication system with an extended double-width AMC.

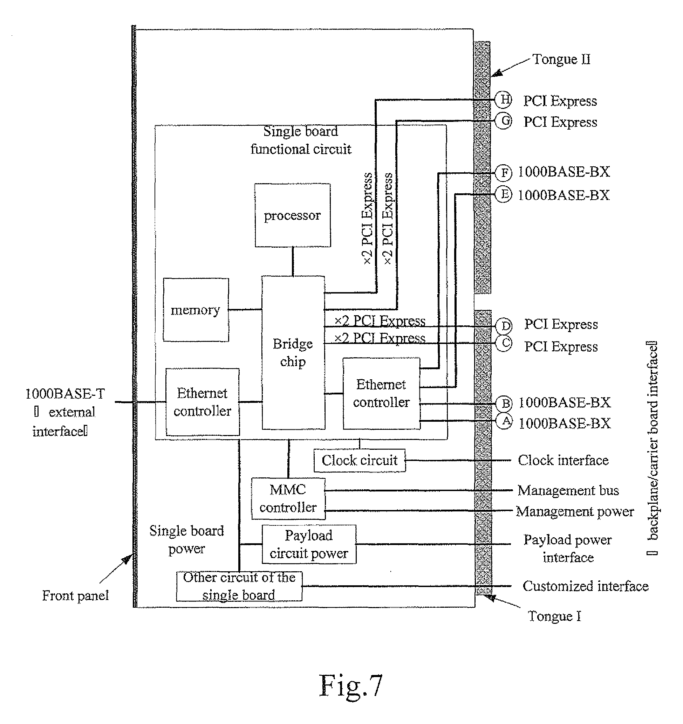

Fig. 7 shows a block diagram of the extended double-width AMC according to the embodiment, which includes a functional circuit, a first Tongue I and a second Tongue II. the functional circuit is adapted to realizing the service processing, system control and network interfacing functions of a board ,and the structure of the functional circuit is substantially the same as that of Fig. 3, mainly including a processor, a memory, a bridge chip, an Ethernet Controller, a MMC controller and a Power. The backplane interfaces provided by Tongue I include two serial PCI standard (PCI express) interfaces and two gigabit Ethernet Interfaces (1000BASE-BX) as well as an IPMB bus interface, a Management Power interface and a payload power interface. The backplane interface included in Tongue II is Fabric Interface for Fabric switch, including two PCI Express Interfaces and two 1000-BASE-BX interfaces. The relationship between the port numbers and the correspondingly signal definitions of the Fabric Interface of the AMC port in the above exemplary embodiment is listed in Table. 1,

**Table 1**

| | Connector Region | | AMC Port# | Signal Definition | Non-redundant MCH fabric interface# | Redundant MCH#7 MCH Fabric Interface# |
|---|---|---|---|---|---|---|
| Tongue I | Basic | Basic Channel | 0 | AMC.2 1000BASE-BX | A | 1/A |
| | | | 1 | AMC.2 1000BASE-BX | | 2/A |
| | | | 2 | | | |
| | | | 3 | | | |
| | | Fabric Channel | 4 | AMC.1 ×2PCI-E | B | 1/B |
| | | | 5 | | | |
| | | | 6 | AMC.1 ×2PCI-E | | 2/B |
| | | | 7 | | | |
| | Extended | Extended Fabric Channel | 8 | | | |
| | | | 9 | | | |
| | | | 10 | | | |
| | | | 11 | | | |
| | | Fabric Channel | 12 | | | |
| | | | 13 | | | |
| | | | 14 | | | |
| | | | 15 | | | |
| | | | 17 | | | |
| | | | 18 | | | |
| | | | 19 | | | |
| | | | 20 | | | |
| Tongue II | Basic | Basic Channel | 0 | AMC.2 1000BASE-BX | A | 1/A |
| | | | 1 | AMC.2 1000BASE-BX | | 2/A |
| | | | 2 | | | |
| | | | 3 | | | |
| | | Fabric Channel | 4 | AMC.1 ×2 PCI-E | B | 1/B |
| | | | 5 | | | |
| | | | 6 | AMC.1 ×2 PCI-E | | 2/B |
| | | | 7 | | | |
| | Extended | Extended Fabric Channel | 8 | | | |
| | | | 9 | | | |
| | | | 10 | | | |
| | | | 11 | | | |
| | | Extended Channel | 12 | | | |
| | | | 13 | | | |
| | | | 14 | | | |
| | | | 15 | | | |
| | | | 17 | | | |
| | | | 18 | | | |
| | | | 19 | | | |
| | | | 20 | | | |

In Table 1, the AMC port # 0 and 1 in Tongue I correspond to backplane interfaces A and B in Fig. 7 respectively, and the AMC port # 4 and 5 to backplane interface C in Fig. 7, AMC port # 6 and 7 to backplane interface D in Fig. 7. The AMC port # 0 and 1 in Tongue II correspond to backplane interfaces E and F in Fig. 7 respectively, and the AMC port # 4 and 5 to backplane interface G in Fig. 7, AMC port # 6 and 7 to backplane interface H in Fig. 7. Furthermore, the last two columns of Table 1 show the corresponding relationship between the AMC port# and the MCH Fabric number, in the case that a non-redundant MCH is used in the Fabric.

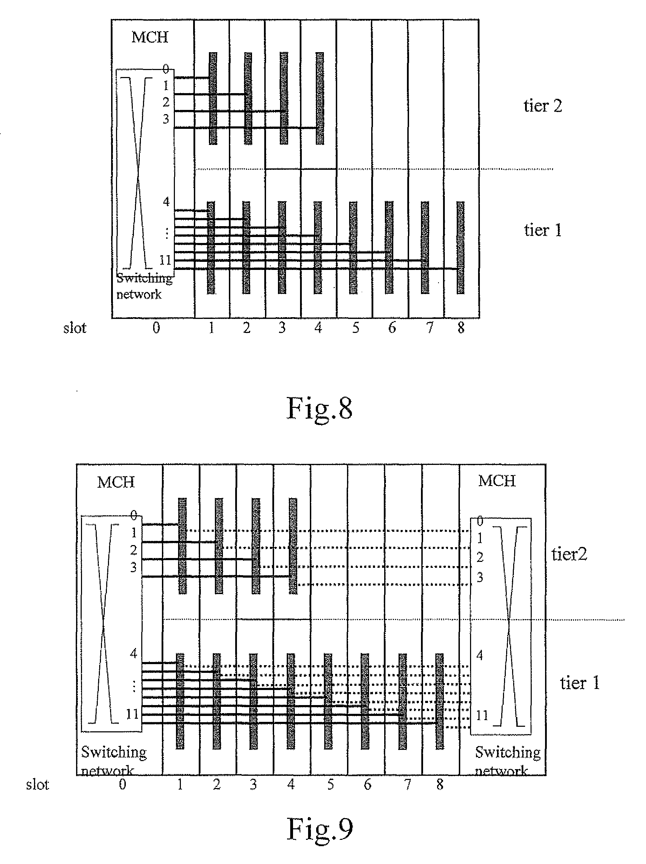

Fig. 8 shows a schematic diagram of a MicrwoTCA system with Mixed width AMC and non-redundant MCH. It can be seen from Fig. 8 that slots 1 and 2 each are inserted by an extended double-width AMC provided by the embodiment, and slots 3 and 4 each are inserted by two single-width AMCs, and slots 5, 6, 7 and 8 each are inserted by an existing double-width AMC.

The Fabric ports corresponding to the twelve links provide by the MCH in Fig. 8 can also have two configurations.

In one configuration, there are 12 Fabric ports in the MCH, that is, the link, Fabric port and AMC Fabric Interface correspond to each other one-by-one. Therefore, one double-width AMC is connected to two Fabric ports, and each Fabric port provides a switching bandwidth that is single time of the link rate. Taking the case of the Fabric Interface of the AMC being a GE port as an example, the detailed port mapping relationship is shown in Table. 2.

**Table 2**

| Fabric Link # | Fabric Port # | Corresponding AMC, | AMC Fabric Interface and Bandwidth |
|---|---|---|---|
| 0 | 0 | Slot 1 | 2 separate GE ports, total bandwidth2 × 1000Mb/s |
| 4 | 4 | | |
| 1 | 1 | Slot 2 | separate GE ports, total bandwidth 2 × 1000mb/s |
| 5 | 5 | | |
| 2 | 2 | Slot 3/ Tier 2 | 1 GE port, bandwidth1 × 1000Mb/s |
| 6 | 6 | Slot 3 / Tier 1 | GE port, bandwidth 1 × 1000Mb/s |
| 3 | 3 | Slot 4 / Tier 2 | 1 GE port, bandwidth 1 × 1000Mb/s |
| 7 | 7 | Slot 4 / Tier 1 | 1GE port, bandwidth 1 × 1000Mb/s |
| 8 | 8 | Slot 5 | 1GE port, bandwidth 1 × 1000Mb/s |
| 9 | 9 | Slot 6 | 1GE port, bandwidth 1 × 1000Mb/s |
| 10 | 10 | Slot 7 | 1GE port, bandwidth 1 × 1000Mb/s |
| 11 | 11 | Slot 8 | 1GE port, bandwidth 1 × 1000Mb/s |

In the other configuration, there are 10 Fabric ports in the MCH, Links 0 and 4 connecting with the double-width AMC in Slot 1 are connected to one MCH Fabric port after being aggregately bound by a IEEE 802.3ad link, and links 1 and 5 connecting with the double-width AMC in Slot 2 are connected to one MCH Fabric port after being aggregately bound by IEEE 802.3ad link. Thus, two Fabric ports both provide a switching bandwidth of double link rate , and other Fabric ports each provide a switching bandwidth that is single time of the link rate, similar to that of the first configuration. Taking the case of the Fabric Interface of the AMC being a GE port as an example, the detailed port mapping is shown in Table. 3.

**Table 3**

| Fabric Link # | Fabric Port # | Corresponding AMC, | AMC Fabric Interface and Bandwidth |
|---|---|---|---|
| 0 | 0 | Slot 1 | 1 Ethernet port (802.3ad), bandwidth 2 × 1000Mb/s |
| 4 | | | |
| 1 | 1 | Slot 2 | 1Ethernet port (802.3ad), bandwidth 2 × 1000Mb/s |
| 5 | | | |
| 2 | 2 | Slot 3 / Tier 2 | 1 GE port, bandwidth 1 × 1000Mb/s |
| 6 | 6 | Slot 3 / Tier 1 | 1G port, bandwidth 1 × 1000Mb/s |
| 3 | 3 | Slot 4 / Tier 2 | 1GE port, bandwidth 1 × 1000Mb/s |
| 7 | 7 | Slot 4 / Tier 1 | 1CE port, bandwidth 1 × 1000Mb/s |
| 8 | 8 | Slot 5 | 1GE port, bandwidth 1 × 1000Mb/s |
| 9 | 9 | Slot 6 | 1GE port, bandwidth 1 × 1000Mb/s |
| 10 | 10 | Slot 7 | 1GE port, bandwidth 1 × 1000Mb/s |
| 11 | 11 | Slot 8 | 1GE port, bandwidth 1 × 1000Mb/s |

Fig. 9 shows a schematic diagram of a MicrwoTCA system with Mixed width AMC and redundant MCH, It can be seen from Fig. 9 similar to Fig. 8, an extended double-width AMC provided by the embodiment is plugged into slots 1 and 2 respectively, and two single-width AMCs are plugged into slots 3 and 4 respectively, and an existing double-width AMC is plugged into slots 5, 6, 7 and 8 respectively.

The Fabric ports in Fig. 9 can also have two configurations. In the first configuration, there are 12 Fabric ports, that is, the same Fabric port of different MCHs is connected to the fabric interface of the same AMC Tongue via link, thus one double-width AMC is connected to two Fabric ports of different numbers and each Fabric port provides a switching bandwidth of double link rate. Taking the AMC fabric interface being PCI Express port as an example, the link rate of each PCI Express is 2.5Gbs, as the detailed port mapping shown in Table 4. In the other configuration, there are 10 switching ports. Two links of the double-width AMC in Slot 1, which are connected to an MCH, are bound together to be connected to one Fabric port of the MCH. Similarly, two links of the double-width AMC, which are connected to a further MCH, are bound together to be connected to one Fabric port of the further MCH. The same Fabric port on the two MCHs is adapted to connect to the same double-width AMC. Thereby, the double-width AMC is connected to one Fabric port after binding four links of the double-width AMC. Similarly, the double-width AMC in slot 2 is connected to one Fabric port after binding four links of the double-width AMC. Each of the two Fabric ports provides a switching bandwidth that is four times of the link rate. The rest of the Fabric ports are the same as in the first configuration, which provide a switching bandwidth that is two times of the link rate. When the AMC Fabric port is PCI Express port, and the link rate of each PCI Express is 2.5Gbs, the detailed port mapping is shown as an example in Table 5.

**Table 4**

| Fabric Link # | Fabric port # | Corresponding AMC | AMC Fabric Interface and Bandwidth |
|---|---|---|---|
| 0 | 0 | Slot 1 | 2 separate PCI Express port, bandwidth of each port 5Gb/s |
| 4 | 4 | | |
| 1 | 1 | Slot 2 | 2 separate PCI Express port bandwidth of each port 5Gb/s |
| 5 | 5 | | |
| 2 | 2 | Slot 3 / Tier 2 | 1PCI Express port, bandwidth 5Gb/s |
| 6 | 6 | Slot 3 / Tier 1 | 1PCI Express port, bandwidth 5Gb/s |
| 3 | 3 | Slot 4 / Tier 2 | 1PCI Express port, bandwidth 5Gb/s |
| 7 | 7 | Slot 4 / Tier 1 | 1PCI Express port, bandwidth 5Gb/s |
| 8 | 8 | Slot 5 | 1PCI Express port, bandwidth 5Gb/s |
| 9 | 9 | Slot 6 | 1PCI Express port, bandwidth 5Gb/s |
| 10 | 10 | Slot 7 | 1PCI Express port, bandwidth 5Gb/s |
| 11 | 11 | Slot 8 | 1PCI Express port, bandwidth 5Gb/s |

**Table 5**

| Fabric Link # | Fabric port #1 | Corresponding AMC, | AMC Fabric Interface and Bandwidth |
|---|---|---|---|
| 0 | 0 | Slot 1 | 1 PCI Express port, bandwidth 10Gb/s |
| 4 | 4 | | |
| 1 | 1 | Slot 2 | 1 PCI Express port, bandwidth 10Gb/s |
| 5 | 5 | | |
| 2 | 2 | Slot 3 / Tier 2 | 1 PCI Express port, bandwidth 5Gb/s |
| 6 | 6 | Slot 3 / Tier 1 | 1 PCI Express port, bandwidth 5Gb/s |
| 3 | 3 | Slot 4 / Tier 2 | 1 PCI Express port, bandwidth 5Gb/s |
| 7 | 7 | Slot 4 / Tier 1 | 1 PCI Express port, bandwidth 5Gb/s |
| 8 | 8 | Slot 5 | 1 PCI Express port, bandwidth 50b/s |
| 9 | 9 | Slot 6 | 1 PCI Express port, bandwidth 5Gb/s |
| 10 | 10 | Slot 7 | 1 PCI Express port, bandwidth 5Gb/s |
| 11 | 11 | Slot 8 | 1 PCI Express port, bandwidth 5Gb/s |

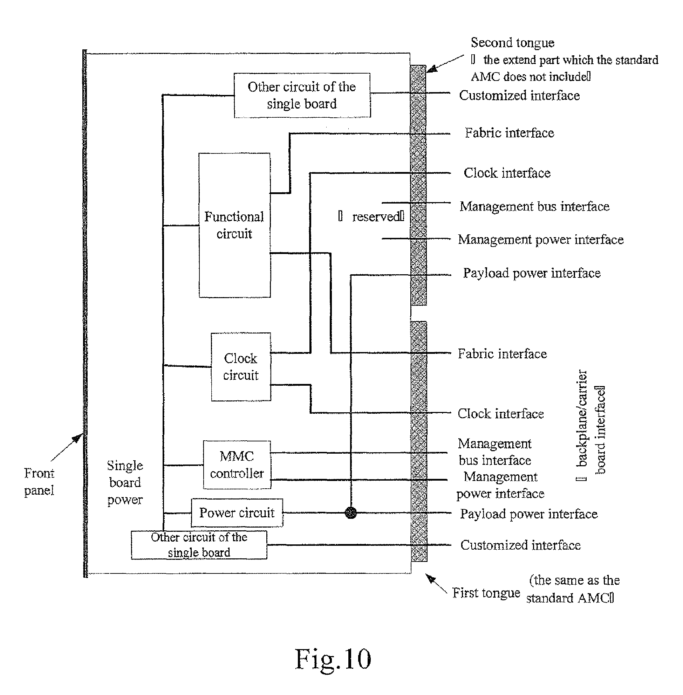

In a second embodiment of the present invention, the first Tongue provides a Fabric Interface, a Management Interface and a Power Interface, and the second Tongue provides a Fabric Interface, a Management Interface and a Power Interface as well, and the Management Interface can be reserved. Thus, an AMC including such first and second Tongues is shown in detail in Fig. 10. In the first Tongue of the AMC, the Fabric Interface is connected to the functional circuit, the Clock Interface is connected to the clock circuit on the board, the Management Bus Interface and Management Power interface is connected to the MMC controller, and the payload Power Interface is connected to the power circuit; in the second Tongue, the Fabric Interface is connected to the functional circuit, the Clock Interface is connected to the clock circuit on the board, and the payload Power Interface is connected to the power circuit, while the Management Bus Interface and Management Power interface are reserved. Here, in the first and second Tongues, the signal connection channels included in each interface are substantially the same as the corresponding ports in the first embodiment. Furthermore, as shown in Fig. 10, the application of the AMC to the MicroTCA system and ATCA system is the same as the first embodiment, which will be omitted for clarity.

The above are detailed descriptions of the embodiments of the present invention, and the following may be seen from the above embodiments.

In the embodiments of the present invention, one more Tongue is extended on a double-width AMC, and the extended Tongue provides interface for connecting with the functional circuit, thereby the double-width AMC can provide more interfaces and the connection resources of the double-width AMC are fully used.

In the embodiments of the present invention, the extended Tongue may provide a Fabric Interface, thus the extended double-width AMC according to the embodiments of the present invention may provide a switching bandwidth that is two times of that of the standard double-width AMC.

In the embodiments of the present invention, the extended Tongue can provide a Power Interface and other signal interfaces, for extending the AMC connection resources or providing a power supply with larger power.

Furthermore, in a MirroTCA communication system with Mixed width AMC according to the embodiments of the present invention, the Fabric port capacity is increased, by connecting the two links of the double-width AMC whose two Tongues are connected to the same MCH to one Fabric port of the same MCH after binding the two links together.

In an AMC carrier board of the embodiments of the present invention, by plugging the extended double-width AMC of the embodiments of the present invention into a slot of the carrier board that has the slot supporting two single-width AMCs, the AMC connection resources are extended, the interface resources providing by the AMC carrier board is fully used, and the switching bandwidth of the extended double-width AMC is increased, or a lager power is provided.

The above is only preferred embodiments of the disclosure, and is not intended to limit the scope of the disclosure. Any modification, equivalent substitution and improvement within the spirit and scope of the disclosure are intended to be included in the scope of the disclosure.

## Claims

1. A double-width Advanced Mezzanine Card, comprising a functional circuit, wherein the double-width Advanced Mezzanine Card further comprises a first Tongue and a second Tongue;
both the first and second Tongues have interfaces that are connected to the functional circuit.

2. The double-width Advanced Mezzanine Card of claim 1, wherein the interfaces of the first Tongue comprise a Fabric Interface, a Power Interface, a Clock Interface, a Management Interface and other universal interfaces or any combination of the above interfaces;
the interfaces of the second Tongue comprise a Fabric Interface, a Power Interface, a Clock Interface, a Management Interface and other universal interfaces or any combination of the above interfaces;
the interfaces included in the first and second Tongues together include at least a Fabric Interface, a Power Interface, a Clock Interface and a Management Interface.

3. The double-width Advanced Mezzanine Card of claim 1, wherein,
the Fabric Interface is a connecting interface for the AMC to communicate with a MicroTCA system Hub (MCH) or an AMC carrier board;
the Management Interface includes an Intelligent Platform Management Bus IPMB interface and a Management Power Interface;
the Power Interface is a payload power interface;
the Clock Interface is an interface for the AMC to connect to a system clock;
the other universal interfaces are user-defined interfaces or interfaces defined in the standard except for the above interfaces.

4. A communication system having an Advanced Mezzanine Card (AMCs), wherein the communication system comprises a backplane, and the backplane has a slot into which two single-width AMCs may be plugged, , and the communication system further comprises a double-width AMC having a first Tongue and a second Tongue, wherein the double-width AMC is plugged into the slot;
both the first and second Tongues have backplane interfaces that are connected to corresponding backplane interfaces on the slot.

5. The communication system of claim 4, wherein the backplane interfaces of the first Tongue comprise a Fabric Interface, a Power Interface, a Clock Interface, a Management Interface and other universal interfaces or any combination of the above interfaces;
the backplane interfaces of the second Tongue comprise a Fabric Interface, a Power Interface, a Clock Interface, a Management Interface and other universal interfaces or any combination of the above interfaces;
the backplane interfaces included in the first and second Tongues together include at least a Fabric Interface, a Power Interface, a Clock Interface and a Management Interface.

6. The communication system of claim 4, wherein the communication system further comprises an MCH inserted in an MCH slot on the backplane;
the backplane interfaces of both the first and second Tongues comprise Fabric Interfaces, the Fabric Interfaces of the first Tongue are connected to a Fabric port on the MCH via the backplane, and the Fabric Interfaces of the second Tongue are connected to a Fabric port on the MCH via the backplane.

7. The communication system of claim 6, wherein the MCH is non-redundantly configured.

8. The communication system of claim 6, wherein the MCH is redundantly configured, and each Fabric Interface of the two Tongues of the double-width AMC is connected to the same Fabric interface on each MCH.

9. The communication system of claim 6, wherein two links through which the Fabric Interfaces of the two Tongues of the double-width AMC are connected to the same MCH, are connected to different Fabric ports.

10. The communication system of claim 6, wherein two links, through which the Exchange Interfaces of the two Tongues of the double-width AMC are connected to the same MCH, are bound together to be connected to the same Fabric port.

11. A communication unit having an Advanced Mezzanine Card (AMC), , wherein the communication unit includes an AMC carrier board having a slot into which two single-width AMCs may be plugged, and the communication unit further comprises a double-width AMC having a first Tongue and a second Tongue;
both the first and second Tongues have carrier board interfaces, the carrier board interfaces of both Tongues are respectively connected to the AMC carrier board via the slot.

12. The communication unit of claim 11, wherein the carrier board interfaces of the first Tongue comprise a Fabric Interface, a Power Interface, a Clock Interface, a Management Interface and other universal interfaces or any combination of the above interfaces;
the carrier board interfaces of the second Tongue comprise a Fabric Interface, a Power Interface, a Clock Interface, a Management Interface and other universal interfaces or any combination of the above interfaces;
the interfaces included in the first and second Tongues together include at least a Fabric Interface, a Power Interface, a Clock Interface and a Management Interface.

13. The communication unit of claim 11, wherein the carrier board interfaces of both the first and second Tongues comprise Fabric Interfaces, and the Fabric Interfaces of both the Tongues are respectively connected to two physical ports on the AMC carrier board via the slot.

14. The communication unit of claim 13, wherein the two physical ports are configured to be two separate logical ports or a single logical port.
